# EUROPÄISCHE PATENTSCHRIFT

(11) **EP 1 713 315 B1**
(45) Veröffentlichungstag und Bekanntmachung des Hinweises auf die Patenterteilung: **10.12.2008**
(21) Anmeldenummer: 06112429.3
(22) Anmeldetag: 10.04.2006
(51) Int. Cl.: H05K 7/14

(54) **Anordnung elektrischer bzw. elektronischer Geräte**
Eelectric and/or electronic apparatus arrangement
Arrangement de boîtier électrique ou/et électronique

(30) Priorität: 11.04.2005 DE 102005016760
(43) Veröffentlichungstag der Anmeldung: 18.10.2006
(73) Patentinhaber: Jetter AG, 71642 Ludwigsburg (DE)
(72) Erfinder: Busch, Thomas, 71711 Steinheim (DE); Götz, Dieter, 71686 Remseck (DE); Kraut, Andreas, 71642 Ludwigsburg (DE)
(74) Vertreter: Bongen, Renaud & Partner

(56) Entgegenhaltungen:
- EP-A- 0 078 405
- EP-A2- 0 236 711
- EP-A2- 0 896 504
- DE-A1- 3 308 510
- DE-A1- 3 924 161
- DE-A1- 10 040 651
- DE-U1- 29 713 960

## Beschreibung

Die Erfindung bezieht sich auf die Anordnung elektrischer bzw. elektronischer Geräte gemäß dem Oberbegriff des Anspruches 1.

Derartige Anordnungen sind aus der DE 33 08 510 A1 bekannt. Dabei müssen die Gehäusemodule aus einer relativ großen Vielzahl unterschiedlicher, jedoch ähnlich aussehender Flachteile zusammengesteckt werden.

Gemäß der EP 0 236 711 A2 sind bei einer alternativen Anordnung Sockelkörper sowie Gehäusekörper mit unterschiedlichen Abmessungen in Längsrichtung der Tragschiene vorgesehen. So kann beispielsweise ein in Schienenlängsrichtung schmaler Gehäusesockel lediglich mit einem entsprechend schmalen Gehäusekörper kombiniert werden, während in Längsrichtung der Tragschiene breitere Sockelkörper zur Aufnahme zweier schmaler Gehäusekörper oder eines entsprechend großen Gehäusekörpers geeignet sind. Die Sockelkörper umfassen Steckeranordnungen, die einerseits mit den in den Gehäusekörpern unterzubringenden Schaltungsanordnungen und andererseits über Kabelanordnungen mit den Steckeranordnungen benachbarter Sockelteile verbindbar sind, so dass sich durchgehende elektrische Leitungen zur Energieversorgung oder Datenverbindung der Schaltungsanordnungen schaffen lassen.

Gemäß der EP 0 896 504 B1 sind bei einer weiteren Ausführungsform die Sockelteile mit einstückig angeformten Steckerteilen versehen, die bei benachbarter Anordnung der Sockelteile nebeneinander zwangsläufig unter Bildung von Daten- und/oder Energiebusleitungen verbunden werden. Desweiteren besitzt jedes Sockelteil ein einstückig angeformtes weiteres Steckerteil, welches mit einem am jeweiligen Gehäusemodul angeordneten Gegenstecker elektrisch verbindbar und mit den erstgenannten Steckerteilen verbunden ist.

Die DE 39 24 161 C3 zeigt Anordnungen mit explosionsgeschützten Innenräumen für elektronische Schaltungen.

Diese vorbekannten Anordnungen sind in der Herstellung und/oder bezüglich ihrer Montage vergleichsweise aufwändig.

Deshalb ist es Aufgabe der Erfindung, eine durch verbesserten modularen Aufbau besonders flexibel ausbildbare Anordnung zu schaffen.

Diese Aufgabe wird erfindungsgemäß dadurch gelöst, dass gleichartige Sockelteile sowie zu jeweils einem Sockelteil und/oder zu zwei oder mehreren nebeneinander angeordneten Sockelteilen passende Gehäusekörper vorgesehen sind.

Die Erfindung beruht auf dem allgemeinen Gedanken, bei Bedarf unterschiedlich große Gehäuse vorzusehen, diese jedoch unter Verwendung untereinander gleichartiger Sockelteile zu erstellen.

Damit wird der Vorteil geboten, dass die Sockelteile an der Tragschiene ohne Berücksichtigung der später montierbaren Gehäusekörper nebeneinander angeordnet werden können und darüber hinaus eine nachträgliche Änderung der jeweiligen Gehäusegröße ohne Demontage der Sockelteile möglich bleibt.

Gemäß einer besonders bevorzugten Ausführungsform der Erfindung bestehen die zu jeweils einem Sockelteil passenden Gehäusekörper im wesentlichen aus zwei Schalenteilen, die jeweils eine im montierten Zustand zur Schienenlängsrichtung im wesentlichen senkrechte große Gehäuseseite und miteinander verbindbare, im montierten Zustand im wesentlichen in Schienenlängsrichtung erstreckte Seitenstücke aufweisen.

Damit wird gleichzeitig die vorteilhafte Möglichkeit geboten, dass die zu jeweils zwei nebeneinander angeordneten Sockelteilen passenden Gehäusekörper im wesentlichen aus den zwei vorgenannten Schalenteilen, die den zu jeweils einem Sockelteil passenden Gehäusekörper bilden, sowie einem Zwischenteil bestehen können, welches zwischen den Seitenstücken der Schalenteile zur Anpassung des Abstandes zwischen den Schalenteilen an die Gesamtbreite der zwei Sockelteile anbringbar ist.

Falls der Gehäusekörper zu mehr als zwei nebeneinander angeordneten Sockelteilen passen soll, genügt es, die Zwischenteile entsprechend mehrfach zwischen den beiden Schalenteilen anzuordnen.

Erfindungsgemäß ist also für die Gehäuse eine stark modularisierte Struktur vorgesehen.

In zweckmäßiger Ausgestaltung der Erfindung sind die Schalenteile als Trag- bzw. Aufnahmeteile für Platinen mit Schaltungsanordnungen ausgebildet. Dabei ist vorteilhaft, dass zunächst die Platinen an den Schalenteilen angeordnet und die Schalenteile erst danach miteinander oder einem der Zwischenteile verbunden werden können, wobei gegebenenfalls auch am Zwischenteil eine weitere Schaltungsanordnung zuvor angeordnet werden kann.

An den Sockelteilen können davon trennbare Steckermodule angeordnet sein, die einerseits mit dem Steckermodul zumindest eines benachbarten Sockelteiles und andererseits mit Steckerelementen der Schaltungsanordnungen in den Gehäusemodulen verbindbar sind. Im Gegensatz zu Sockelteilen, an denen die Steckermodule einstückig angeformt sind, wird durch die von den Sockelteilen gesonderten Steckermodule die Möglichkeit geschaffen, die elektrische Verschaltung der Steckermodule gegebenenfalls leicht verändern zu können.

Im übrigen wird hinsichtlich bevorzugter Merkmale der Erfindung auf die Ansprüche und die nachfolgende Erläuterung der Zeichnung verwiesen, anhand der besonders bevorzugte Ausführungsformen der Erfindung näher beschrieben werden.

Dabei wird Schutz nicht nur für ausdrücklich beanspruchte bzw. dargestellte Merkmalskombinationen sondern prinzipiell auch für beliebige Unterkombinationen dieser Merkmale beansprucht.

In der Zeichnung zeigt
- Fig. 1: eine perspektivische Gesamtdarstellung einer erfindungsgemäßen Anordnung elektronischer Geräte,
- Fig. 2: eine perspektivische Explosionsdarstellung eines mit nur einem Sockelteil kombinierten Gehäusemoduls,
- Fig. 3: eine entsprechende Explosionsdarstellung eines mit zwei Sockelteilen kombinierten Gehäusemoduls,
- Fig. 4: ein Sockelteil in Kombination mit einem Steckermodul,
- Fig. 5: das Steckermodul der Fig. 4 in Einzeldarstellung,
- Fig. 6: zwei Sockelteile mit kombiniertem Steckermodul und
- Fig. 7: eine Einzeldarstellung dieses Steckermoduls.

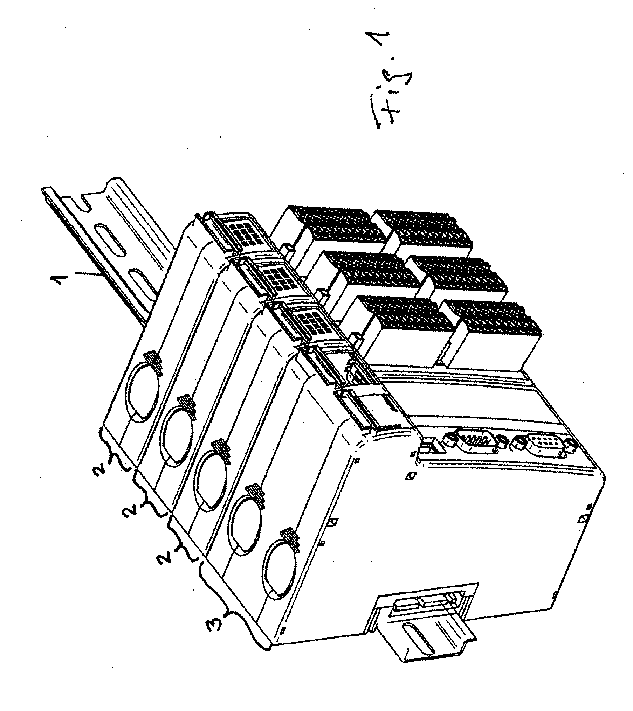

Gemäß Fig. 1 ist an einer nicht dargestellten Wandfläche eine Tragschiene 1 angeordnet, die im wesentlichen einen auf der Wandfläche aufliegend montierbaren Mittelbereich und daran beidseitig anschließende abgekröpfte Seitenbereiche mit von der Wandfläche beabstandeten, im wesentlichen wandparallelen Randstegen aufweist.

An dieser Tragschiene sind Gehäusemodule 2 bzw. 3, die elektrische bzw. elektronische Schaltungsanordnungen aufnehmen, nebeneinander benachbart montierbar. Die Gehäusemodule 2 besitzen in Längsrichtung der Tragschiene eine vergleichsweise geringe Breite (z.B. 25mm), während die Gehäusemodule 3 eine doppelte Breite (z.B. 50mm) aufweisen.

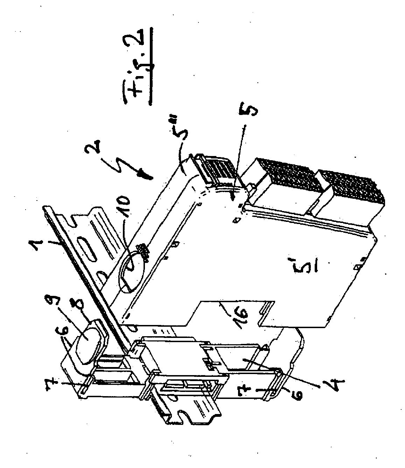

Gemäß Fig. 2 besteht das Gehäusemodul 2 im wesentlichen aus einem an der Tragschiene 1 montierbaren Sockelteil 4, welches die tragschienenseitige Seite des Gehäuses 2 bildet, sowie einem Gehäusekörper 5, welches seinerseits im wesentlichen aus zwei Schaltenteilen 5' und 5" besteht. Diese Schalenteile 5', 5" bilden zwei quer zur Längsrichtung der Tragschiene 1 erstreckte große Gehäuseseitenflächen, an die jeweils abgewinkelte Seitenteile angeformt sind, die die schmalen Gehäuseseitenflächen bilden und zur Verbindung der Schalenteile 5' und 5" miteinander dienen.

Der Gehäusekörper 5 lässt sich senkrecht zur Wandebene, an der die Tragschiene 1 angeordnet ist, auf das Sockelteil 4 aufschieben, wobei das Sockelteil 4 an seinen zur Wandfläche senkrechten Seiten im wesentlichen vollständig umschlossen wird und gegebenenfalls an den Innenseiten der Schalenteile 5' bzw. 5" angeordnete Stege oder Rinnen mit entsprechenden Stegen oder Rinnen 6,7 am Sockelteil 4 formschlüssig in Eingriff kommen können.

Am Sockelteil 4 sind blattfederartige Rastzungen 8 angeordnet, die mit auf ihnen angeordneten Erhebungen 9 in der montierten Endlage des Gehäusemoduls 5 am Sockelteil 4 in Ausnehmungen 10 eingreifen, die am Gehäusemodul 5 im Bereich der Seitenstücke der Schalenteile 5' und 5" ausgebildet sind.

Falls der Gehäusekörper 5 vom Sockelteil 4 der Fig. 2 wieder getrennt werden soll, werden die Rastzungen 8 durch Druck auf ihre Erhebungen 9 niedergedrückt, so dass der Riegeleingriff der Erhebungen 9 in den Ausnehmungen 10 aufgehoben und der Gehäusekörper 5 vom Sockelteil 4 abgezogen werden kann.

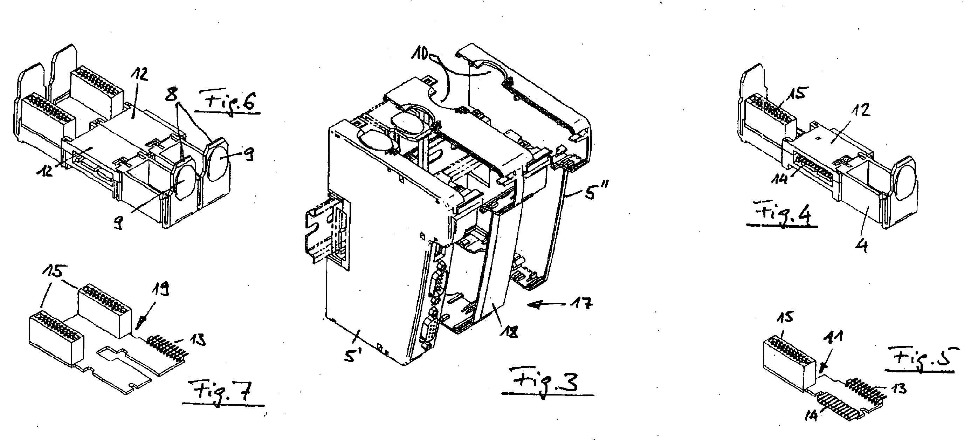

Wie insbesondere aus den Fig. 4 und 5 ersichtlich ist, lässt sich in das Sockelteil 4 das in Fig. 5 dargestellte Steckermodul 11 einlegen und durch ein vom Sockelteil 4 trennbares Abdeckteil 12 am Sockelteil 4 formschlüssig haltern.

Das Steckermodul 11 besitzt seitliche Stecker- und Buchsenelemente 13, 14, die so angeordnet sind, dass sie sich automatisch elektrisch mit den Stecker- bzw. Buchsenelementen des Steckermoduls 11 des jeweils benachbarten Sockelteils 4 verbinden, wenn zwei Sockelteile 4 in Längsrichtung der Tragschiene 1 in eine aneinander anliegende Position gebracht werden. Ein am Steckermodul 11 angeordnetes weiteres Steckerteil 15 dient zur elektrischen Verbindung mit Schaltungsanordnungen, die innerhalb des Gehäusekörpers 5 angeordnet sind.

In seiner montierten Endlage am Sockelteil 4 umfasst der Gehäusekörper 5 das Abdeckteil 12 mit Rändern von Aussparungen 16, die an den die großen Gehäuseseitenflächen bildenden Schalenteilen 5' und 5" ausgebildet sind und mit dem Abdeckteil 12 anschlagartig zusammenwirken, wenn das Gehäusemodul 5 seine vorgesehene Endlage am Sockelteil 4 erreicht.

Das größere Gehäuse 3 wird gemäß Fig. 3 durch zwei unmittelbar nebeneinander angeordnete Sockelteile 4 sowie einen grö-βenmäßig entsprechend angepassten Gehäusekörper 17 gebildet. Dieser besitzt die gleichen Schalenteile 5' und 5" wie der Gehäusekörper 5 der Fig. 2, jedoch ist zwischen den Schalenteilen 5' und 5" ein Zwischenteil 18 eingesetzt, welches jeweils mit den in Längsrichtung der Tragschiene 1 erstreckten Seitenstücken der Schalenteile 5' und 5" verbindbar ist, so dass der Abstand der Schalenteile 5' und 5" an die Breite von zwei nebeneinander angeordneten Sockelteilen 4 angepasst ist.

Dabei ist das Zwischenteil 18 so ausgebildet, dass zwischen dem Zwischenteil 18 und den beiden angrenzenden Schaltenteilen 5' und 5" wiederum Ausnehmungen 10 für die Erhebungen 9 der Rastzungen 8 der beiden nebeneinander angeordneten Sockelteile gebildet werden.

Wie insbesondere aus den Fig. 6 und 7 ersichtlich ist, kann für die beiden Sockelteile 4 des großen Gehäuses 3 ein gemeinsames Steckermodul 19 vorgesehen sein, welches zwei Steckerteile 15 trägt, die so angeordnet sind, dass sie jeweils benachbart zu den großen Seitenflächen der Schalenteile 5' und 5" des Gehäusekörpers 17 positioniert sind.

Damit wird der Tatsache Rechnung getragen, dass innerhalb der Gehäuse 2 und 3 angeordnete Schaltungsanordnungen in der Regel an den Schalenteilen 5' und 5" gehalterte Platinen und/oder Gegensteckelemente aufweisen, die beim Aufsetzen des jeweiligen Gehäusemoduls 5 bzw. 17 auf die jeweiligen Sockelteile 4 mit den Steckerteilen 15 der Steckermodule 11 und 19 verbunden werden.

Grundsätzlich können die Sockelteile 4 eines großen Gehäusemoduls 3 auch mit Steckermodulen 11 gemäß Fig. 5 ausgerüstet sein.

Wie die Fig. 1, 2 und 3 zeigen, können an den von der Tragschiene 1 abgewandten Seiten der Schalenteile 5' und 5" sowie der Zwischenteile 18 Ausschneidungen für Steckeranordnungen oder dergleichen vorgenommen werden, die zum Anschluss von Kabeln oder dergleichen dienen, um die in den Gehäusemodulen 2 und 3 aufgenommenen Schaltungsanordnungen mit externen Geräten elektrisch verbinden zu können.

Gemäß einer besonders bevorzugten Ausführungsform können die Gehäusemodule 5 die darin angeordneten elektronischen Schaltungen auch dann allseitig gegen absichtlichen oder unabsichtlichen Eingriff schützen, wenn die Gehäusemodule 5 von den zugeordneten Sockelanordnungen 4 getrennt werden. Zu diesem Zweck kann vorgesehen sein, dass die der Sockelanordnung 4 zugewandte Seite des jeweiligen Gehäusemoduls 5 durch eine zwischen den Schalenteilen 5' und 5" angeordnete bzw. anbringbare Wand, die gegebenenfalls durch an den Schalenteilen angeformte Stege gebildet werden kann, abgeschlossen ist. Außerdem kann vorgesehen sein, innenseitig der Ausnehmungen 10 innerhalb des jeweiligen Gehäusemoduls 5 eine die Ausnehmung 10 von innen überlappende Wand anzuordnen, die sich innenseitig der mit der Ausnehmung zusammenwirkenden Rastzunge 8 erstreckt, wenn das Gehäusemodul mit der zugeordneten Sockelanordnung 4 verbunden ist. Auch wenn das Gehäusemodul 5 von der Sockelanordnung getrennt wird und dementsprechend die Ausnehmung 10 nicht mehr von der Rastzunge 8 verschlossen wird, entsteht somit über die Ausnehmung 10 kein Zugang zum Innenraum des Gehäusemoduls 5. Außerdem wird einer möglichen Verletzungsgefahr vorgebeugt, die dadurch entstehen könnte, dass ein schlanker Finger einer Hand versehentlich in das Gehäusemodul eingreifen könnte. Die vorgenannte Wand kann durch Stegteile gebildet werden, die an den Schalenteilen 5' und 5" bzw. am Zwischenteil 18 angeformt sind.

Teile der in Längsrichtung der Tragschiene 1 erstreckten Seiten der Gehäusemodule 5 können durch Flachteile 50 gebildet werden, die sich beim Zusammenbau der Gehäusemodule formschlüssig zwischen zwei Schalenteile 5' und 5" und das Zwischenteil 18 einsetzen lassen. Dabei ist eine Ausbildung bevorzugt, bei der sich das Flachteil unter Vertauschung seiner rechten und linken Ränder einbauen lässt. Wenn das Flachteil 50 beispielsweise als Abdeckung eines Lichterfeldes ausgebildet ist, welches entweder an einer am Schalenteil 5' oder am Schalenteil 5" angeordneten Platine angeordnet sein kann, lässt sich das Flachteil unabhängig von der Anordnung des Lichterfeldes in richtiger Orientierung zu der jeweils das Lichterfeld tragenden Platine einsetzen.

## Patentansprüche

1. Anordnung elektrischer bzw. elektronischer Geräte mit nebeneinander an einer Tragschiene (1) anbringbaren, zur Aufnahme elektrischer bzw. elektronischer Schaltungsanordnung dienenden Gehäusemodulen (2,3), welche jeweils eine an der Tragschiene (1) anbringbare Sockelanordnung (4) sowie einen mit der Sockelanordnung verbindbaren Gehäusekörper (5,17) aufweisen, wobei
gleichartige Sockelteile (4) sowie zu jeweils einem Sockelteil (4) und/oder zu zwei oder mehreren nebeneinander angeordneten Sockelteilen (4) passende Gehäusemodule (5,17) vorgesehen sind, die zu jeweils zu einem Sockelteil (4) passenden Gehäusekörper (5) im wesentlichen aus zwei Schalenteilen (5',5'') bestehen, die jeweils eine im montierten Zustand zur Schienenlängsrichtung im wesentlichen senkrechte große Gehäuseseite und miteinander verbindbare, im montierten Zustand in Schienenlängsrichtung erstreckte Seitenstücke aufweisen und die zu jeweils mehreren nebeneinander angeordneten Sockelteilen (4) passenden Gehäusekörper (17) im wesentlichen aus den vorgenannten zwei Schalenteilen (5',5''), sowie einem Zwischenteil (18) bestehen, welches zwischen den Seitenstücken der Schalenteile (5',5'') zur Anpassung des Abstandes der Schalenteile an die Gesamtbreite der mehreren Sockelteile (4) anbringbar ist.

2. Anordnung nach Anspruch 1,
**dadurch gekennzeichnet,**
**dass** die Schalenteile (5',5'') als Trag- bzw. Aufnahmeteile für Schaltungsanordnungen bzw. Platinen von Schaltungsanordnungen ausgebildet sind.

3. Anordnung nach einem der Ansprüche 1 oder 2,
**dadurch gekennzeichnet,**
**dass** die Gehäusekörper (5,17) senkrecht zu einer Sockelebene auf die Sockelteile (4) aufschiebbar sind.

4. Anordnung nach einem der Ansprüche 1 bis 3,
**dadurch gekennzeichnet,**
**dass** an den Sockelteilen (4) angeordnete Rastzungen (8) in Ausnehmungen (10) eingreifen, die an den Seitenstücken der Schalenteile (5',5'') bzw. an dem die Seitenstücke verbindenden Zwischenteil (18) oder den Zwischenteilen (18) ausgebildet sind.

5. Anordnung nach einem der Ansprüche 1 bis 4,
**dadurch gekennzeichnet,**
**dass** an den Sockelteilen (4) Steckermodule (11,19) angeordnet sind, die einerseits mit dem Steckermodul zumindest eines benachbarten Sockelteils und andererseits mit Steckerelementen der Schaltungsanordnungen in den Gehäusekörpern (5,17) verbindbar sind.

## Claims

1. Arrangement of electrical and/or electronic devices with housing modules (2, 3), which can be attached next to one another on a mounting rail (1), are used for accommodating electrical and/or electronic circuit arrangements and each have a socket arrangement (4), which can be attached on the mounting rail (1), and a housing body (5, 17), which can be connected to the socket arrangement, identical socket parts (4) and housing modules (5, 17), which fit so as to form in each case one socket part (4) and/or so as to form two or more socket parts (4) arranged next to one another, being provided, the housing bodies (5), which fit so as to form in each case one socket part (4), comprising substantially two shell parts (5', 5"), which each have a large housing side, which is substantially perpendicular with respect to the rail longitudinal direction in the fitted state, and lateral pieces, which can be connected to one another and which extend in the fitted state in the rail longitudinal direction, and the housing bodies (17), which fit so as to form in each case a plurality of socket parts (4) arranged next to one another, substantially comprising the abovementioned two shell parts (5', 5'') and an intermediate part (18), which can be attached between the lateral pieces of the shell parts (5', 5'') so as to match the distance between the shell parts to the overall width of the plurality of socket parts (4).

2. Arrangement according to Claim 1, **characterized in that** the shell parts (5', 5'') are in the form of mounting or accommodating parts for circuit arrangements or printed circuit boards of circuit arrangements.

3. Arrangement according to either of Claims 1 and 2, **characterized in that** the housing bodies (5, 17) can be pushed onto the socket parts (4) perpendicular to a socket plane.

4. Arrangement according to one of Claims 1 to 3, **characterized in that** latching tongues (8) arranged on the socket parts (4) engage in cutouts (10), which are formed on the lateral pieces of the shell parts (5', 5'') or on the intermediate part (18) connecting the lateral pieces or on the intermediate parts (18).

5. Arrangement according to one of Claims 1 to 4, **characterized in that** plug modules (11, 19), which can be connected firstly to the plug module of at least one adjacent socket part and secondly to plug elements of the circuit arrangements in the housing bodies (5, 17), are arranged on the socket parts (4).

## Revendications

1. Arrangement d'appareils électriques ou électroniques comprenant des modules de boîtier (2, 3) pouvant être montés les uns à côté des autres sur un rail porteur (1) et servant à accueillir un arrangement de circuit électrique ou électronique, lesquels présentent respectivement un arrangement de socle (4) pouvant être monté sur le rail porteur (1) ainsi qu'un corps de boîtier (5, 17) pouvant être relié avec l'arrangement de socle, des parties de socle (4) identiques ainsi que des modules de boîtier (5, 17) adaptés à chaque fois à une partie de socle (4) et/ou à deux ou plusieurs parties de socle (4) disposées l'une à côté de l'autre étant prévus, lesquels modules de boîtier se composent pour l'essentiel de deux parties de coque (5', 5'') formant un corps de boîtier (5) à chaque fois adapté pour une partie de socle (4), lesquelles présentent un grand côté de boîtier sensiblement perpendiculaire au sens longitudinal du rail en situation montée ainsi que des pièces latérales pouvant être assemblées entre elles et qui s'étendent dans le sens longitudinal du rail en situation montée et qui se composent pour l'essentiel des deux parties de coque (5', 5'') mentionnées précédemment formant à chaque fois un corps de boîtier (17) adaptés à plusieurs parties de socle (4) disposées les unes à côté des autres ainsi que d'une partie intérieure (18) qui peut être montée entre les pièces latérales des parties de coque (5', 5") pour adapter l'espacement des parties de coque à la largeur totale des plusieurs parties de socle (4).

2. Arrangement selon la revendication 1, **caractérisé en ce que** les parties de coque (5', 5") sont réalisées sous la forme de parties porteuses ou d'accueil pour des arrangements de circuit ou des platines d'arrangements de circuit.

3. Arrangement selon la revendication 1 ou 2, **caractérisé en ce que** les corps de boîtier (5, 17) peuvent être coulissés sur les parties de socle (4) perpendiculairement à un plan de socle.

4. Arrangement selon l'une des revendications 1 à 3, **caractérisé en ce que** les languettes d'enclenchement (8) disposées sur les parties de socle (4) viennent en prise dans des creux (10) qui sont formés sur les pièces frontales des parties de coque (5', 5'') ou sur la partie intermédiaire (18) ou les parties intermédiaires (18) qui relient les pièces latérales.

5. Arrangement selon l'une des revendications 1 à 4, **caractérisé en ce que** des modules enfichables (11, 19) sont disposés sur les parties de socle (4), lesquels peuvent être reliés d'un côté avec le module enfichable d'au moins une partie de socle voisine et de l'autre côté avec des éléments enfichables des arrangements de circuit dans les corps de boîtier (5, 17).
